(19) Europäisches Patentamt
European Patent Office
Office européen des brevets

(11) **EP 4 214 056 B1**

(12) **EUROPÄISCHE PATENTSCHRIFT**

(45) Veröffentlichungstag und Bekanntmachung des Hinweises auf die Patenterteilung:
**10.04.2024   Patentblatt 2024/15**

(21) Anmeldenummer: **22706243.7**

(22) Anmeldetag: **10.02.2022**

(51) Internationale Patentklassifikation (IPC):
**B41F 9/10** (2006.01)   **H05K 3/12** (2006.01)
**D21G 3/00** (2006.01)   **B41N 10/00** (2006.01)
**B41F 31/20** (2006.01)   **B41F 31/02** (2006.01)
**B41F 15/44** (2006.01)   **B41F 15/42** (2006.01)
**B05C 11/04** (2006.01)   **B05C 1/08** (2006.01)

(52) Gemeinsame Patentklassifikation (CPC):
**B41F 9/1072; B05C 1/0817; B05C 11/045;**
**B41F 15/42; B41F 15/44; B41F 31/027;**
**B41F 31/20; D21G 3/00;** B05C 1/083;
B41P 2235/21; H05K 3/1233; H05K 2203/0139

(86) Internationale Anmeldenummer:
**PCT/DE2022/100115**

(87) Internationale Veröffentlichungsnummer:
**WO 2022/171251 (18.08.2022 Gazette 2022/33)**

(54) **RAKEL**

DOCTOR BLADE

RACLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.02.2021   DE 102021103315**

(43) Veröffentlichungstag der Anmeldung:
**26.07.2023   Patentblatt 2023/30**

(73) Patentinhaber: **TKM Meyer GmbH**
**22941 Bargteheide (DE)**

(72) Erfinder:
• **SAUDER, Christian**
**42119 Wuppertal (DE)**

• **STÖRTE, Thomas**
**22941 Bargteheide (DE)**

(74) Vertreter: **RGTH**
**Patentanwälte PartGmbB**
**Neuer Wall 10**
**20354 Hamburg (DE)**

(56) Entgegenhaltungen:
EP-A1- 0 061 093      EP-A1- 1 930 160
WO-A1-92/06796      AT-B- 349 423
DE-A1- 10 120 117      DE-A1- 19 512 696
DE-T2- 60 120 483      DE-T2- 69 527 829
FR-A1- 2 707 918      US-A- 4 055 119
US-A- 5 685 221      US-A1- 2008 257 184
US-A1- 2009 120 355      US-B1- 6 527 913

**Beschreibung**

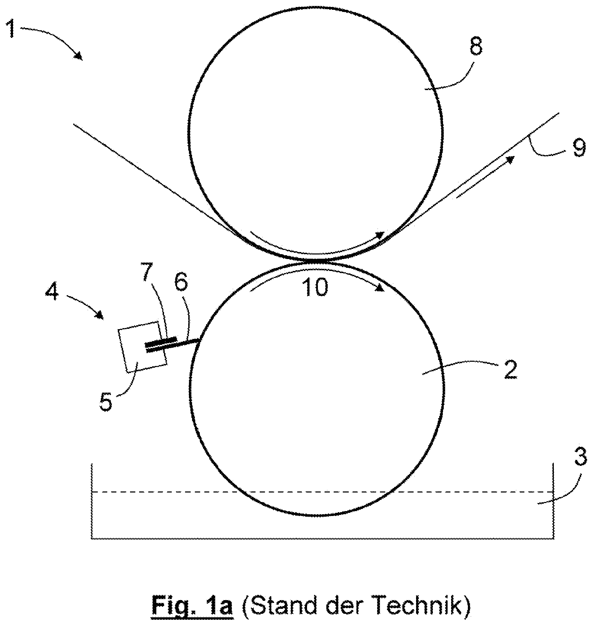

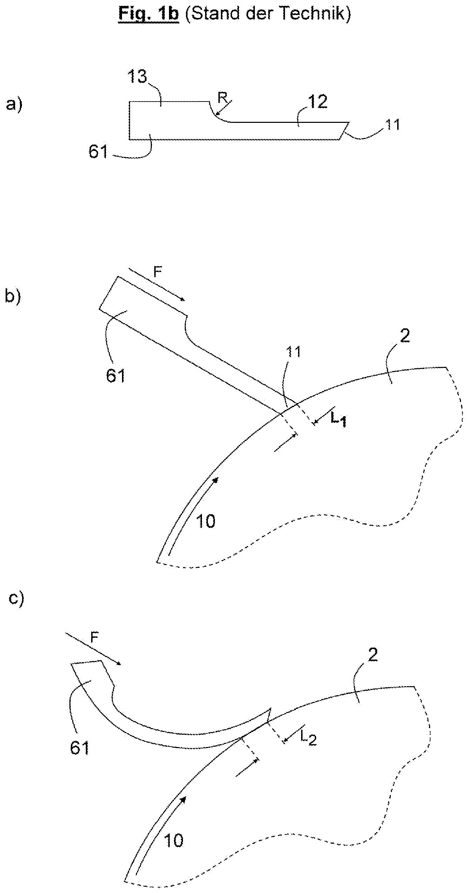

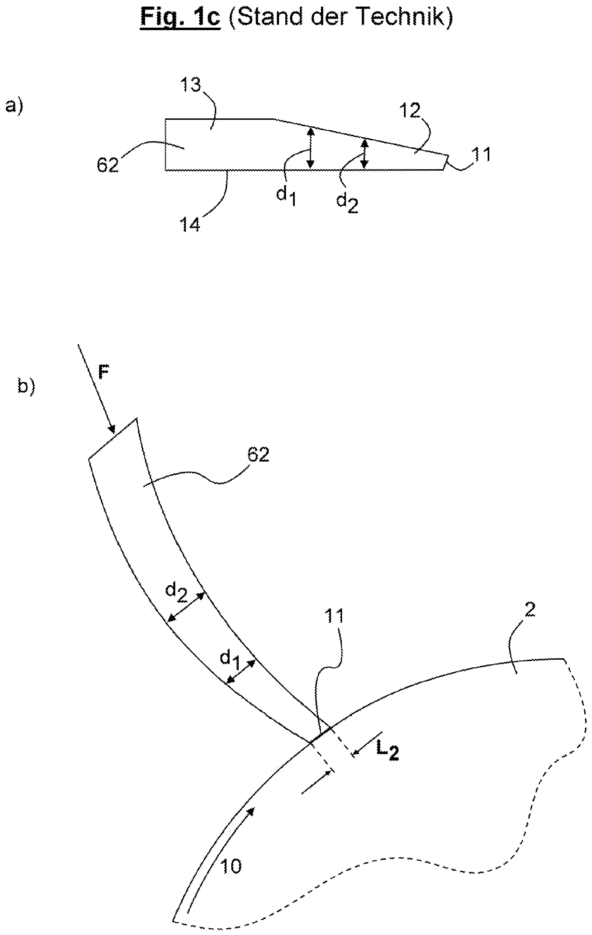

Die vorliegende Erfindung betrifft eine Rakel, insbesondere für Druckzylinder und Beschichtungsanlagen, mit einer Rakelkante, einem Rakelkörper, der durch eine Rakeloberseite und eine Rakelunterseite begrenzt ist, und einem bogenförmigen Lamellenprofil, das zwischen der Rakelkante und dem Rakelkörper ausgebildet ist. Gattungsgemäße Rakeln sind insbesondere für Tiefdruck-, Flexodruck-, Offsetdruck-und Digitaldruckmaschinen bekannt. Fig. 1a zeigt exemplarisch zur Erläuterung der Funktionsweise einer Rakel eine schematische Darstellung eines Druckwerks einer Tiefdruckmaschine 1. Beim Tiefdruckverfahren sind abzubildende Elemente als Vertiefungen, den sog. Näpfchen, in die Oberfläche eines Druckzylinders 2 eingebracht, der innerhalb eines Farbbades 3 rotiert und dort an der gesamten Oberfläche Farbe aufnimmt. Durch eine in Rotationsrichtung 10 nachgeordnete Rakelvorrichtung 4 mit einem Rakelhalter 5, einer darin gehaltenen Rakel 6 und einer (optionalen) Stützrakel 7 wird überschüssige Farbe von der Oberfläche des Druckzylinders 2 abgerakelt bzw. abgewischt, so dass die Farbe lediglich in den Näpfchen des Druckzylinders 2 verbleibt. Die in den Näpfchen verbliebene Farbe wird anschließend auf eine Papierbahn 9 übertragen, die hierzu zwischen dem Druckzylinder 2 und einem gegenläufig rotierenden Gegendruckzylinder 8 geführt wird. In Rotationsrichtung 10 des Druckzylinders 2 gesehen, nimmt der Druckzylinder 2 anschließend wieder Farbe im Farbbad 3 auf und es ergibt sich ein kontinuierlicher Druckprozess.

Zur Durchführung der genannten Druckverfahren werden üblicherweise Rakeln eingesetzt, die als messerartig geschliffenes Stahlband ausgebildet sind. Die Fig. 1b, c zeigen exemplarisch zwei unterschiedliche und nach dem Stand der Technik bekannte Rakeln, jeweils während des bestimmungsgemäßen Gebrauchs sowie im unbelasteten Zustand.

Fig. 1b zeigt in der Teilfigur a) eine Rakel 61 im unbelasteten Zustand, deren Lamellenprofil 12 von der Rakelkante 11 ausgehend zunächst einen linearen Abschnitt aufweist, der über einen kreisförmigen Abschnitt mit dem Radius R in den Rakelkörper 13 übergeht. Die Rakelkante 11 ist gegenüber der linearen Oberseite des Lamellenprofils 12 um einen Winkel von ca. 70° geneigt. Beim Rakeln wird die Rakel 61 gemäß der Teilfigur b) mit ihrer Rakelkante 11 in Kraftrichtung F auf den Druckzylinder 2 gedrückt, so dass eine Kontaktfläche der Breite $L_1$ entsteht. Aufgrund des rotierenden Druckzylinders 2 wird die Rakel 61 an ihrer Rakelkante 11 um ein Maß in Rotationsrichtung 10 des Druckzylinders 2 ausgelenkt, sodass auf die Rakel 61 eine Biegespannung wirkt. In der Praxis hat sich gezeigt, dass derartige Rakeln 61 mit zunehmendem Verschleiß und der dadurch steigenden Biegespannung dazu neigen, sich tangential an die Oberfläche des Druckzylinders 2 anzulegen, wie es in Teilfigur c) dargestellt ist, womit sich allerdings eine vergleichsweise breitere Kontaktfläche $L_2$ ergibt und der Liniendruck sinkt, mit der die Rakel 61 auf den Druckzylinder 2 drückt. Hierdurch schwimmt die Rakel 61 zumindest partiell auf und es ergibt sich verschleißbedingt ein unzureichendes Rakelergebnis, weil partiell Restfarbe auf dem Druckzylinder 2 auch außerhalb der Näpfchen verbleibt und somit kein einwandfreies Druckergebnis erzielbar ist. Die Standzeit einer solchen Rakel 61 ist daher limitiert, weshalb die Rakel 61 in regelmäßigen Abständen ausgetauscht werden muss, was nachteiliger Weise mit einer arbeitsintensiven Montage einer neuen Rakel 61 und dem wartungsbedingten Stillstand der Tiefdruckmaschine 1 verbunden ist.

Fig. 1c zeigt in Teilfigur a) eine Rakel 62, die ein Lamellenprofil 12 mit einer linearen Steigung von ca. 2° gegenüber der Rakelunterseite 14 aufweist, so dass die Rakeldicke $d_1$, $d_2$ mit zunehmendem Abstand von der Rakelkante 11 steigt. Beim bestimmungsgemäßen Gebrauch einer solchen Rakel 62 (vgl. Teilfigur b) wird die Rakelkante 11 auf die Oberfläche des Druckzylinders 2 gedrückt. Mit zunehmendem Verschleiß sinkt aufgrund der größer werdenden Auflagefläche der spezifische Liniendruck, womit auch bei dieser Rakelgeometrie verschleißbedingt das Rakelergebnis unbefriedigend ist und die Rakel 62 ausgetauscht werden muss, um ein nach wie vor einwandfreies Druckergebnis zu erzielen. Auch bei der Rakel 62 nach Fig. 1c ergeben sich die zuvor angesprochenen Nachteile hinsichtlich der verschleißbedingt erforderlichen Wartungsarbeiten.

Rakeln der gattungsgemäßen Art werden darüber hinaus in Beschichtungsanlagen eingesetzt, um beispielsweise Heiß- oder Kaltsiegelklebstoffe feinschichtig auf Papier, Kartonagen oder Folien aufzutragen.

Zumindest teilweise sind solche Rakeln auch bekannt aus AT 349423 B, DE 10120117 A1, DE 19512696 A1, DE 60120483 T2, DE 69527829 T2, EP 61093A1, EP 1930160 A1, FR 2707918 A1, US 4055119 A, US 5685221 A, US 20080257184 A1, US 20090120355 A1, WO 1992006796 A1 und US 6 527 913 B1.

Hiervon ausgehend ist es die Aufgabe der vorliegenden Erfindung, eine Rakel zu schaffen, die den Wartungsaufwand einer Tiefdruck-, Flexodruck-, Offsetdruck-, Digitaldruckmaschine und/oder einer Beschichtungsanlage verringert und die Standzeit einer Rakel erhöht.

Diese Aufgabe wird durch die Rakel nach Anspruch 1 gelöst. Erfindungsgemäß ist zunächst vorgesehen, dass das bogenförmigen Lamellenprofil im unbelasteten Zustand der Rakel und in Bezug auf ein kartesisches Koordinatensystem von der Rakelkante bis zum Rakelkörper einen kubischen Verlauf aufweist, wobei die y-Achse des kartesischen Koordinatensystems mit der Rakelkante zusammenfällt und die x-Achse des kartesischen Koordinatensystems mit der Rakeloberseite zusammenfällt. Hierunter ist ein Verlauf zu verstehen, bei dem die Dicke der Rakel von der Rakelkante bis zum Rakelkörper kubisch zunimmt. Durch diese spezielle Rakelgeometrie, im Bereich des bogenförmigen Lamellenprofils, ergibt sich ein im Wesentlichen verschleißunabhängig konstanter Liniendruck, weil die Änderung der Durchbiegung des Lamellenprofils bzw. der damit verbundenen Änderung der Biegespannung die Änderung der Anlagefläche zwischen Rakel und Druckzylinder und mithin der Rakelkante kompensiert. Hierdurch ergibt sich ein konstantes und einwandfreies Rakelergebnis, das weitestgehend unabhängig von dem Verschleiß der Rakel ist, was sich unmittelbar durch einen geringeren Wartungsaufwand einer Druckmaschine und eine längere Standzeit einer solchen Rakel zeigt.

Bevorzugte Ausgestaltungen der vorliegenden Erfindung werden nachfolgend und in den Unteransprüchen angegeben.

Vorzugsweise ist vorgesehen, dass das bogenförmige Lamellenprofil von der Rakelkante bis zum Rakelkörper einen kubischen Verlauf aufweist, der mindestens eine Wendestelle besitzt. Die Wendestelle kann dabei mit einer Stelle des Verlaufs zusammenfallen, bei der der Verlauf eine positive oder eine negative Steigung aufweist oder bei der die Steigung verschwindet, so dass der Wendepunkt gleichzeitig einen Sattelpunkt bildet. Insbesondere durch einen Bereich mit einer (leicht) fallenden Steigung zwischen dem Wendepunkt und dem Rakelkörper und mithin mit einer (leichten) Dickenabnahme des bogenförmigen Lamellenprofils ergibt sich eine geringere Einlaufzeit, also die Zeit, in der der Kontakt zum Druckzylinder aufgrund des Verschleißes von einem punktuellen zu einem flächigen Aufliegen übergeht.

Im Rahmen einer ersten vorteilhaften Ausgestaltung der vorliegenden Erfindung ist vorgesehen, dass für den Verlauf f(x) des bogenförmigen Lamellenprofils der Rakel mit einer Dicke s an der Rakelkante und einer Dicke t am Rakelkörper von der Rakelkante bis zum Rakelkörper gilt:

$$f(x) = ax^3 + bx^2 + cx + d.$$

Dabei gilt für die Konstanten a, b, c, d im Rahmen eines ersten bevorzugten Ausführungsbeispiels:

$$a > 0, \text{ (b und c)} \geq 0 \text{ und } d = s - t.$$

Mit anderen Worten, die Konstante a ist größer als Null und die Konstanten b und c sind jeweils größer oder gleich Null. Insofern besitzt der Verlauf f(x) des bogenförmigen Lamellenprofils einen kubisch wachsenden Anteil zwischen der Rakelkante und dem Rakelkörper. Dabei bezieht sich hier und im Folgenden der funktional dargestellte Verlauf f(x) des bogenförmigen Lamellenprofils auf eine Rakel, deren Rakelkante am Übergang zum angeschliffenen Bereich des Lamellenprofils auf der y-Achse des kartesischen Koordinatensystems liegt und deren Rakeloberseite mit der x-Achse des kartesischen Koordinatensystems zusammenfällt

Alternativ gilt für die Konstanten a, b, c und d:

$$\text{(a und c)} > 0, b < 0 \text{ und } d = s - t.$$

Durch die negative Konstante b verschiebt sich der Wendepunkt des Verlaufes f(x) in die positive Halbebene (x > 0) und mithin in den Bereich zwischen der Rakelkante und dem Rakelkörper. Hierdurch ergeben sich die zuvor bereits erwähnten Vorteile des bogenförmigen Lamellenprofils.

Die zuvor beschriebenen Bereichsgrenzen für die Konstanten a, b, c und d führen größenabhängig zu unterschiedlichen Verläufen des bogenförmigen Lamellenprofils, auf die nachfolgend nur beispielhaft eingegangen wird.

Für

-

$$a > 0, b = 0, c = 0 \text{ und } d = s - t$$

oder

-

$$a > 0, b > 0, c = 0 \text{ und } d = s - t$$

ergibt sich ein kubisch ansteigender Verlauf des bogenförmigen Lamellenprofils, wobei die Steigung an der Rakelkante verschwindet. Mit anderen Worten, das Lamellenprofil ist im Bereich der Rakelkante parallel zur Rakelunterseite ausgerichtet und es ergibt sich ein Anschliffwinkel an der Rakelkante von 0°.

Für

-

$$a > 0, b = 0, c > 0 \text{ und } d = s - t$$

oder

-

$$a > 0,\ b > 0,\ c > 0 \text{ und } d = s - t$$

ergibt sich ein kubisch ansteigender Verlauf des bogenförmigen Lamellenprofils mit einer an der Rakelkante positiven Steigung. Der Anschliffwinkel an der Rakelkante ist in diesem Fall > 0°.

Nachfolgend werden jeweils Ausführungsbeispiele mit konkreten Bereichsangaben für die Konstanten a, b und c beschrieben.

Im Rahmen einer bevorzugten Ausgestaltung der vorliegenden Erfindung ist bei dem kubischen Verlauf f(x) des bogenförmigen Lamellenprofils für die Konstanten a, b und c vorgesehen:

$$0{,}000485 \le a \le 0{,}0021953,$$

$$3{,}33158 \le b \le 4{,}545127$$

und

$$1{,}468371 \le c \le 25{,}0128.$$

Vorzugsweise gilt bei dem kubischen Verlauf f(x) des bogenförmigen Lamellenprofils für die Konstanten a, b und c:

$$0{,}00068 \le a \le 0{,}00158,$$
$$3{,}3321 \le b \le 4{,}5416 \text{ und}$$
$$10{,}19478 \le c \le 10{,}2501.$$

Im Rahmen der zuvor angesprochenen bevorzugten Ausgestaltungen des bogenförmigen Lamellenprofils sind jeweils nur die Konstanten a, b und c angesprochen, die die Änderung der Dicke des bogenförmigen Lamellenprofils von der Rakelkante bis zum Rakelkörper beschreiben. Die Dicken s, t der Rakel sowohl an der Rakelkante als auch am Rakelkörper sind anwendungsabhängig wählbar, wobei für die Konstante s, t vorzugsweise gilt:

$$60\ \mu m \le s \le 125\ \mu m$$

und

$$150\ \mu m \le t \le 200\ \mu m.$$

In allen Fällen ist die Rakel vorzugsweise aus einem geschliffenen Stahlband gefertigt. Alternativ kann die Rakel aus einem anderen Metall, einer Metalllegierung, Aluminium oder aus Kunststoff, wie beispielsweise aus Polyester, bestehen.

Konkrete Ausführungsformen der Rakel werden nachfolgend mit Bezug auf die Figuren 2a bis 5 erläutert. Es zeigen:

Fig. 2a    eine perspektivische Ansicht einer erfindungsgemäßen Rakel;

Fig. 2b    eine Draufsicht auf die Rakel;

Fig. 2c    eine Querschnittsansicht der Rakel;

Fig. 3a, b    jeweils eine nicht beanspruchte Rakel mit einem quadratischen Verlauf des bogenförmigen Lamellenprofils;

Fig. 4a, b    jeweils eine erfindungsgemäße Rakel mit einem kubischen Verlauf des bogenförmigen Lamellenprofils und

Fig. 5    eine erfindungsgemäße Rakel mit einem bogenförmigen Lamellenprofil, das eine Wendestelle besitzt.

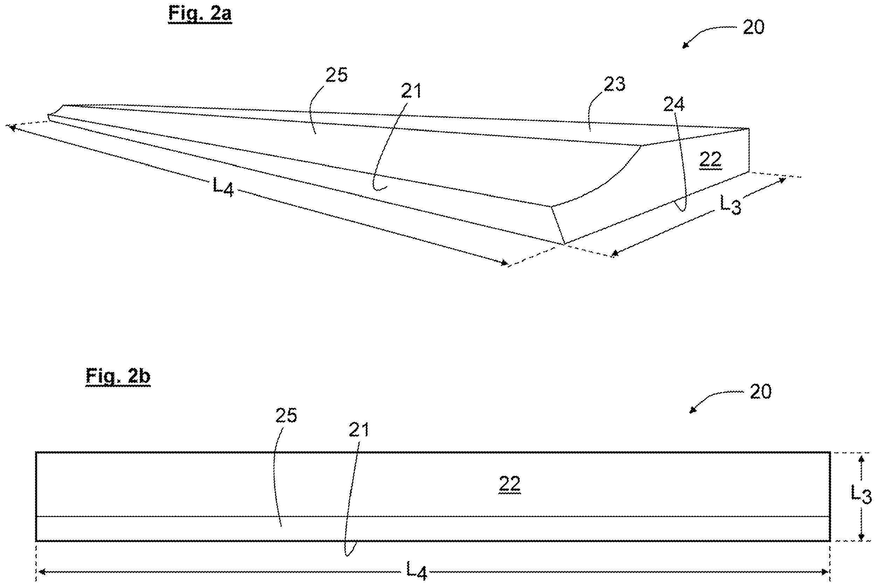

Fig. 2a zeigt eine konkrete Ausführungsform einer Rakel 20 in perspektivischer Darstellung. Die Rakel 20 besteht aus einem geschliffenen Stahlband und besitzt eine Rakelkante 21, die gegenüber einer Horizontalen um ca.

70° geneigt ist und zur Anlage an einem rotierenden Druckzylinder (nicht dargestellt) ausgebildet ist. Alternativ zu einer Neigung der Rakelkante von ca. 70° kann die Rakelkante auch bogenförmig ausgebildet sein. In diesem Zusammenhang hat sich eine konvexe Bogenform insbesondere mit einem konstanten Krümmungsradius als besonders vorteilhaft erwiesen. Hier und den Abbildungen wird jedoch der Einfachheit halber stets eine Rakelkante 21 mit einer Neigung gegenüber der Horizontalen dargestellt. Zur lösbaren Befestigung der Rakel 20 an einem Halter (nicht dargestellt) besitzt die Rakel 20 an der der Rakelkante 21 gegenüberliegenden Seite einen Rakelkörper 22, der durch zwei ebene Flächen, nämlich der Rakeloberseite 23 und der Rakelunterseite 24 begrenzt ist. Zwischen der Rakelkante 21 und dem Rakelkörper 22 erstreckt sich ein bogenförmiges Lamellenprofil 25, das einen kubischen Verlauf aufweist. Derartige Rakeln 20 besitzen typischerweise eine Länge $L_3$ von 20 mm bis 60 mm und werden auf transportfähige Coils von bis zu 100 m aufgewickelt. Im abgelängten und mithin montierbaren Zustand besitzen solche Rakeln 20 anwendungsabhängig typischerweise eine Breite $L_4$ von 80 mm bis 4000 mm.

Fig. 2b zeigt die Draufsicht einer solchen Rakel 20 mit der Rakelkante 21, dem bogenförmigen Lamellenprofil 25 und dem Rakelkörper 22.

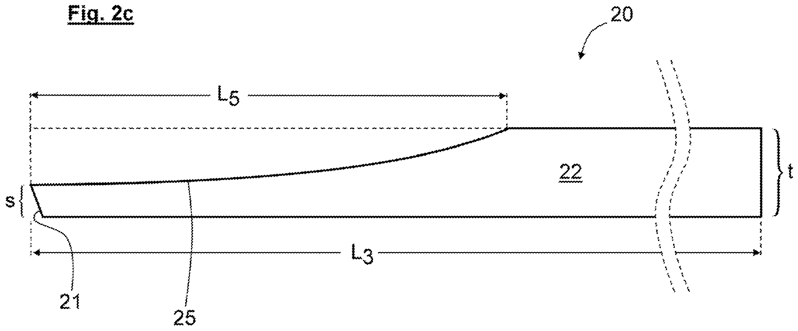

Fig. 2c zeigt eine Querschnittsansicht der Rakel 20, die an ihrer Rakelkante 21 die Dicke s und im Bereich des Rakelkörpers 22 die Dicke t besitzt. Zwischen der Rakelkante 21 und dem Rakelkörper 22 erstreckt sich das bogenförmige Lamellenprofil 25 der Länge Ls, das im dargestellten Ausführungsbeispiel der vorliegenden Erfindung einen kubischen Verlauf aufweist.

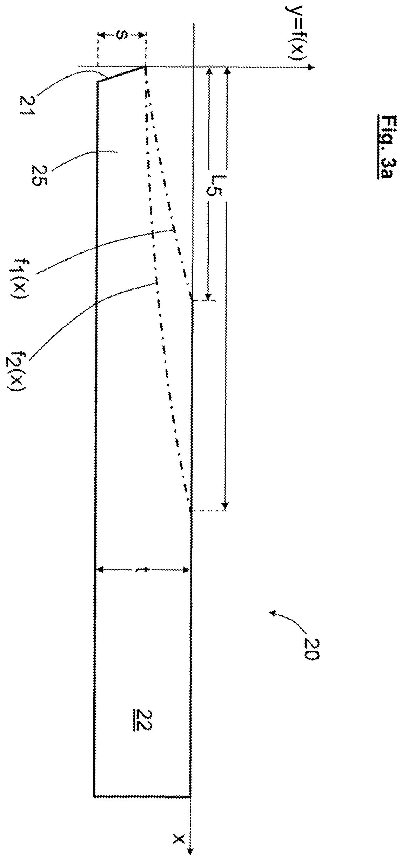

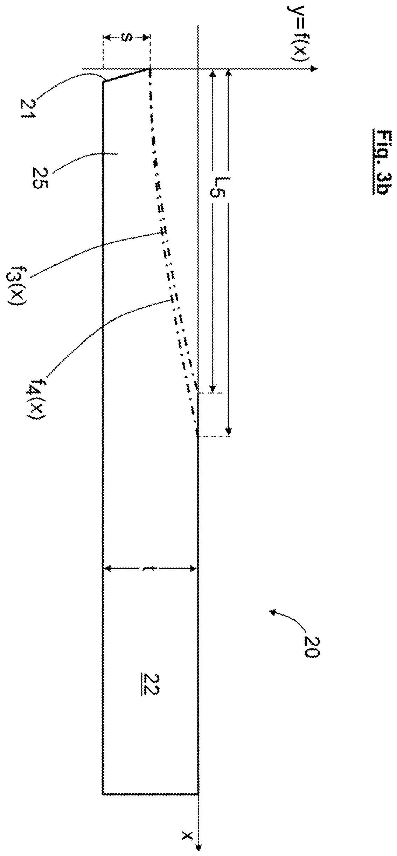

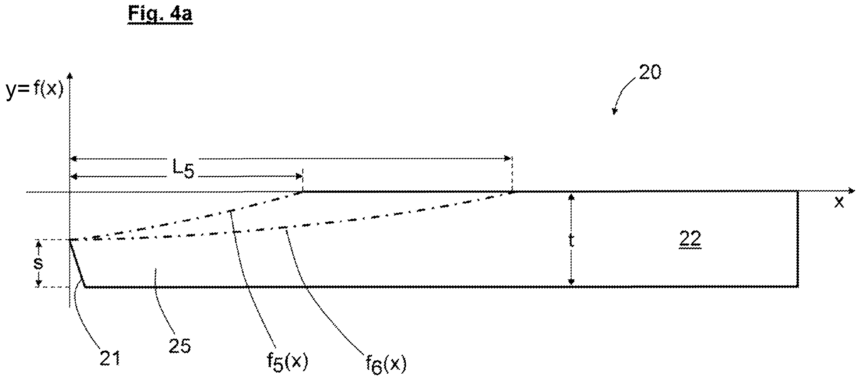

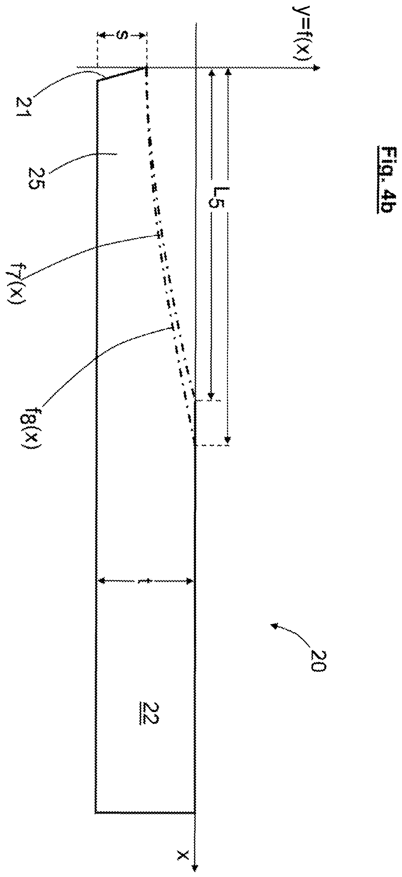

Die Bereichsgrenzen für die Konstanten a, b, c und d führen im Rahmen des kubischen Verlaufs des bogenförmigen Lamellenprofils 25 dazu, dass die möglichen Verläufe eine Kurvenschar bilden, wobei die Kurvenschar einerseits durch eine erste Kurve mit den jeweils kleinstmöglichen Werten für die Konstanten a, b und c und eine zweite Kurve mit den jeweils größtmöglichen Werten der Konstanten a, b und c begrenzt ist. Die Konstante d bewirkt lediglich eine Verschiebung des y-Achsenabschnitts und ist von der bedarfsabhängig wählbaren Dicke s der Rakel 20 an ihre Rakelkante 21 sowie der Dicke t der Rakel 20 an ihrem Rakelkörper 22 abhängig. Jeweils eine konkrete Ausführungsform des Verlaufs der Rakel 20 sind in den Fig. 3a, b sowie 4a, b dargestellt, wobei die Fig. 3a, b einen nicht beanspruchten quadratischen Verlauf f(x) und die Fig. 4a, b einen erfindungsgemäßen kubischen Verlauf f(x) des bogenförmigen Lamellenprofils 25 zeigen. In allen dargestellten Ausführungsbeispielen wird der Übersichtlichkeit halber von einheitlichen Dicken s, t der Rakel 20 an ihrer Rakelkante 21 und ihrem Rakelkörper 22 ausgegangen. Ferner bezieht sich der jeweils funktional dargestellte Verlauf f(x) des bogenförmigen Lamellenprofils 25 auf eine Rakel 20, deren Rakelkante 21 am Übergang zum angeschliffenen Bereich des Lamellenprofils 25 auf der y-Achse eines kartesischen Koordinatensystems liegt und deren Rakeloberseite 23 mit der x-Achse des Koordinatensystems zusammenfällt.

Hiervon ausgehend zeigt Fig. 3a zwei voneinander beabstandete strichlinierte Verläufe f(x), die die äußeren Grenzbereiche der Konstanten a, b und c darstellen. $f_1(x)$ stellt demnach den quadratischen Verlauf f(x) des bogenförmigen Lamellenprofils 25 dar, für den gilt:

$$a = 0, \; b = 4{,}565214, \; c = 25{,}96338, \; s = 70 \; \mu m \; und \; t = 200 \; \mu m.$$

$f_2(x)$ stellt den quadratischen Verlauf f(x) des bogenförmigen Lamellenprofils 25 dar, für den gilt:

$$a = 0, \; b = 3{,}335997, \; c = 1{,}457449, \; s = 70 \; \mu m \; und \; t = 200 \; \mu m.$$

Fig. 3b zeigt einen besonders bevorzugten Teilbereich der Werte für die Konstanten a, b, c, s und t im Rahmen eines quadratischen Verlaufs f(x) des bogenförmigen Lamellenprofils 25. $f_3(x)$ stellt demnach den quadratischen Verlauf f(x) des bogenförmigen Lamellenprofils 25 dar für den gilt:

$$a = 0, \; b = 4{,}55603, \; c = 10{,}21459, \; s = 70 \; \mu m \; und \; t = 200 \; \mu m.$$

$f_4(x)$ stellt im Rahmen des bevorzugten Ausführungsbeispiels den quadratischen Verlauf f(x) des bogenförmigen Lamellenprofils 25 dar, für den gilt:

$$a = 0, \; b = 3{,}33829, \; c = 10{,}017947, \; s = 70 \; \mu m \; und \; t = 200 \; \mu m.$$

In ähnlicher Weise zeigen die Fig. 4a, b eine konkrete Ausführungsform einer erfindungsgemäßen Rakel 20, bei der ein kubischer Verlauf des bogenförmigen Lamellenprofils 25 vorgesehen ist. Konkret zeigen die Fig. 4a, b jeweils zwei voneinander beabstandete strichlinierte Verläufe f(x), die die äußeren Grenzbereiche der Konstanten a, b und c

darstellen. $f_5(x)$ stellt demnach den kubischen Verlauf $f(x)$ des bogenförmigen Lamellenprofils 25 dar, für den gilt:

$$a = 0,0021953, \quad b = 4,545127, \quad c = 25,0128, \quad s = 70\ \mu m \quad und \quad t = 200\ \mu m.$$

$f_6(x)$ stellt den kubischen Verlauf $f(x)$ des bogenförmigen Lamellenprofils 25 dar, für den gilt:

$$a = 0,000485, \quad b = 3,33158, \quad c = 1,468371, \quad s = 70\ \mu m \quad und \quad t = 200\ \mu m.$$

Fig. 4b zeigt einen besonders bevorzugten Teilbereich der Werte für die Konstanten a, b, c, s und t im Rahmen eines kubischen Verlaufs $f(x)$ des bogenförmigen Lamellenprofils 25. $f_7(x)$ stellt demnach den kubischen Verlauf $f(x)$ des bogenförmigen Lamellenprofils 25 dar für den gilt:

$$a = 0,00158, \quad b = 4,5416, \quad c = 10,2501, \quad s = 70\ \mu m \quad und \quad t = 200\ \mu m.$$

$f_8(x)$ stellt im Rahmen des bevorzugten Ausführungsbeispiels den kubischen Verlauf $f(x)$ des bogenförmigen Lamellenprofils 25 dar, für den gilt:

$$a = 0,00068, \quad b = 3,3321, \quad c = 10,19478, \quad s = 70\ \mu m \quad und \quad t = 200\ \mu m.$$

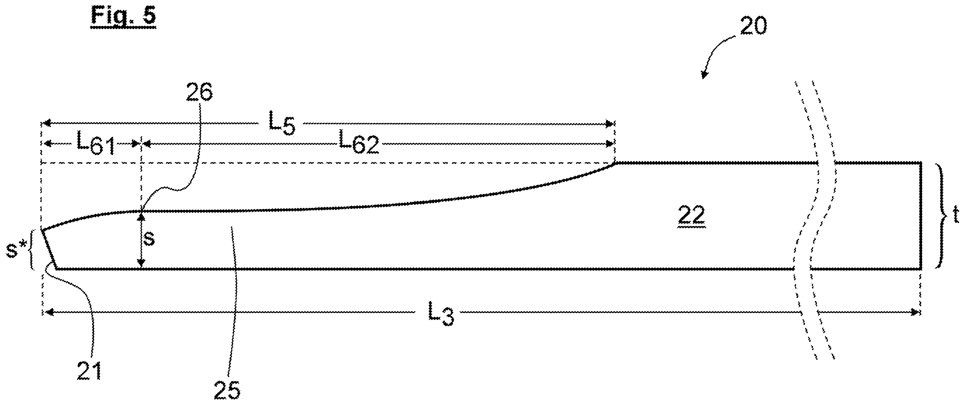

Im Rahmen konkreter Ausführungsformen der vorliegenden Erfindung sind Variationen der Dicke s der Rakel 20 an der Rakelkante 21 und der Dicke t der Rakel 20 am Rakelkörper 22 derart vorgesehen, dass $60\ \mu m \leq s \leq 125\ \mu m$ und $150\ \mu m \leq t \leq 200\ \mu m$ gilt. Hiervon ausgehend ergeben sich bogenförmige Lamellenprofile 25 mit einem kubischen Verlauf $f(x)$, wobei Längen $L_5$ der Lamellenprofile 25 zwischen 0,8 mm und 4,9 mm vorgebbar sind. Schließlich zeigt Fig. 5 eine Rakel 20 mit einem bogenförmigen Lamellenprofil 25 zwischen der Rakelkante 21 und dem Rakelkörper 22, wobei der Verlauf $f(x)$ eine Wendestelle 26 besitzt. Die Wendestelle 26 ist der Schnittpunkt eines ersten Bereiches $L_{61}$ und eines zweiten Bereiches $L_{62}$ des bogenförmigen Lamellenprofils 25, wobei der erste Bereich $L_{61}$ von der Rakelkante 21 ausgehend eine Rechtskrümmung und der zweite Bereich $L_{62}$ eine Linkskrümmung besitzt.

Anders ausgedrückt, an der Wendestelle 26 wechselt eine an das bogenförmige Lammelenprofil 25 angelegte Tangente die Seite. Im dargestellten Ausführungsbeispiel verschwindet die Steigung des bogenförmigen Lamellenprofils 25 an der Wendestelle 26, so dass die Wendestelle 26 mit einem Sattelpunkt zusammenfällt. Konkret gilt an der Wendestelle 26: $f'(x) = f''(x) = 0$. Alternativ hierzu sind auch (nicht dargestellte) Ausführungsbeispiele vorgesehen, bei der der Verlauf $f(x)$ des bogenförmigen Lamellenprofils 25 an der Wendestelle 26 eine positive Steigung besitzt.

Der Bereich $L_{62}$, also der Bereich zwischen der Wendestelle 26 und dem Rakelkörper 22, besitzt einen Verlauf $f(x)$, wie er zuvor im Zusammenhang mit einer Rakel 20 beschrieben wurde, die einen kubischen Verlauf $f(x)$ aufweist. Der Verlauf $f(x)$ ist jedoch um die Länge des Bereichs $L_{61}$ in positive x-Richtung verschoben. An der Wendestelle 26 besitzt die Rakel 20 daher eine Dicke s. Die Wendestelle 26 befindet sich dabei innerhalb der vorderen Hälfte des Lamellenprofils, womit gilt: $L_{61} \leq L_{62}$. Damit besitzt eine Rakel 20 mit einer Wendestelle 26 eine Rakelkante mit einer vergleichsweise geringeren Dicke s*. Konkret gilt für s*: $40\ \mu m \leq s^* \leq s$.

Der Verlauf $f^*(x)$ im Bereich $L_{61}$ folgt einer kubischen Form, wobei sich der Verlauf $f^*(x)$ allgemein mit

$$f^*(x) = a^*x^3 + b^*x^2 + c^*x + s^* - t$$

beschreiben lässt.

Dabei gilt:

$$a^* > a, \quad b^* < 0, \quad 0 < c^* \leq 100, \quad 150\ \mu m \leq t \leq 200\ \mu m \quad und \quad 40\ \mu m \leq s^* < s.$$

**Bezugszeichen**

1 Tiefdruckmaschine
2 Druckzylinder
3 Farbbad
4 Rakelvorrichtung
5 Rakelhalter
6 Rakel (Stand der Technik)
61 Rakel (Stand der Technik)
62 Rakel (Stand der Technik)
7 Stützrakel
8 Gegendruckzylinder
9 Papierbahn
10 Rotationsrichtung
11 Rakelkante
12 Lamellenprofil
13 Rakelkörper
14 Rakelunterseite
20 Rakel
21 Rakelkante
22 Rakelkörper
23 Rakeloberseite
24 Rakelunterseite
25 Lamellenprofil
26 Wendepunkt

a, a*     Konstante
b, b*     Konstante
c, c*     Konstante
d     Konstante
F     Kraftrichtung
s, s*     Dicke der Rakel an der Rakelkante
t     Dicke der Rakel am Rakelkörper
$d_{1,2}$     Dicke der Rakel im Bereich des Lammellenprofils
R     Radius
$L_{1,2}$     Breite der Kontaktfläche
$L_3$     Rakellänge
$L_4$     Rakelbreite
$L_5$     Länge des Lamellenprofils
$L_{61}$     Bereich des Lamellenprofils mit einer Rechtskrümmung
$L_{62}$     Bereich des Lamellenprofils mit Linkskrümmung
f(x), f*(x)     Verlauf des Lamellenprofils

**Patentansprüche**

1. Rakel (20), insbesondere für Druckzylinder und Beschichtungsanlagen, mit einer Rakelkante (21), einem Rakelkörper (22), der durch eine Rakeloberseite (23) und eine Rakelunterseite (24) begrenzt ist, und einem bogenförmigen Lamellenprofil (25), das zwischen der Rakelkante (21) und dem Rakelkörper (22) ausgebildet ist, **dadurch gekennzeichnet, dass** das bogenförmigen Lamellenprofil (25) im unbelasteten Zustand der Rakel (20) und in Bezug auf ein kartesisches Koordinatensystem von der Rakelkante (21) bis zum Rakelkörper (22) einen kubischen Verlauf f(x) aufweist, wobei die y-Achse des kartesischen Koordinatensystems mit der Rakelkante (21) zusammenfällt und die x-Achse des kartesischen Koordinatensystems mit der Rakeloberseite (23) zusammenfällt.

2. Rakel (20) nach Anspruch 1, **dadurch gekennzeichnet, dass** der kubische Verlauf f(x) des bogenförmigen Lamellenprofils (25) eine Wendestelle (26) besitzt.

3. Rakel (20) nach Anspruch 1, **dadurch gekennzeichnet, dass** für den Verlauf f(x) des bogenförmigen Lamellenprofils (25) der Rakel (20) mit einer Dicke s an der Rakelkante (21) und einer Dicke t am Rakelkörper (22) von der Rakelkante (21) bis zum Rakelkörper (22) gilt: $f(x) = ax^3 + bx^2 + cx + d$, wobei für die Konstanten a, b, c, d gilt: a > 0, (b und c)

$\geq$ 0 und d = s - t.

4. Rakel (20) nach Anspruch 1, **dadurch gekennzeichnet, dass** für den Verlauf f(x) des bogenförmigen Lamellenprofils (25) der Rakel (20) mit einer Dicke s an der Rakelkante (21) und einer Dicke t am Rakelkörper (22) von der Rakelkante (21) bis zum Rakelkörper (22) gilt: f(x)=ax$^3$+bx$^2$+cx+d, wobei für die Konstanten a, b, c, d gilt: (a und c) > 0, b < 0 und

$$d = s - t.$$

5. Rakel (20) nach Anspruch 3, **dadurch gekennzeichnet, dass** bei dem kubischen Verlauf f(x) des bogenförmigen Lamellenprofils (25) für die Konstanten a, b und c gilt:

$$0{,}000485 \leq a \leq 0{,}0021953,$$

$$3{,}33158 \leq b \leq 4{,}545127$$

und

$$1{,}468371 \leq c \leq 25{,}0128.$$

6. Rakel (20) nach Anspruch 3, **dadurch gekennzeichnet, dass** bei dem kubischen Verlauf f(x) des bogenförmigen Lamellenprofils (25) für die Konstanten a, b und c gilt:

$$0{,}00068 \leq a \leq 0{,}00158,$$

$$3{,}3321 \leq b \leq 4{,}5416$$

und

$$10{,}19478 \leq c \leq 10{,}2501.$$

7. Rakel (20) nach einem der Ansprüche 3 bis 6, **dadurch gekennzeichnet, dass** für die Dicke s der Rakel (20) an der Rakelkante (21) und der Dicke t der Rakel (20) am Rakelkörper (22) gilt:

60 $\mu$m $\leq$ s $\leq$ 125 $\mu$m und
150 $\mu$m $\leq$ t $\leq$ 200 $\mu$m.

8. Rakel (20) nach einem der Ansprüche 1 bis 7,
**dadurch gekennzeichnet, dass**
die Rakel (20) aus einem geschliffenen Stahlband gefertigt ist.

**Claims**

1. Doctor blade (20), in particular for printing cylinders and coating units, with a doctor blade edge (21), a doctor blade body (22) which is limited by a doctor blade upper side (23) and a doctor blade underside (24), and a curved blade profile (25) which is formed between the doctor blade edge (21) and the doctor blade body (22), **characterized in that,** in the unloaded state of the doctor blade (20) and in relation to a Cartesian coordinate system, the curved blade profile (25) has a cuboidal course f(x) from the doctor blade edge (21) to the doctor blade body (22), wherein the y-axis of the Cartesian coordinate system coincides with the doctor blade edge (21) and the x-axis of the Cartesian coordinate system coincides with the doctor blade upper side (23).

2. Doctor blade (20) according to claim 1, **characterized in that** the cuboidal course f(x) of the curved blade profile (25) has a turning point (26).

3. Doctor blade (20) according to claim 1, **characterized in that** for the course f(x) of the curved blade profile (25) of the doctor blade (20) with a thickness s at the doctor blade edge (21) and a thickness t at the doctor blade body (22) from the doctor blade edge (21) to the doctor blade body (22), the following applies: $f(x) = ax^3 + bx^2 + cx + d$, wherein for the constants a, b, c, d, the following applies: a > 0, (b and c) $\geq$ 0 and d = s - t.

4. Doctor blade (20) according to claim 1, **characterized in that**, for the course f(x) of the curved blade profile (25) of the doctor blade (20) with a thickness s at the doctor blade edge (21) and a thickness t at the doctor blade body (22) from the doctor blade edge (21) to the doctor blade body (22), the following applies: $f(x) = ax^3 + bx^2 + cx + d$, wherein, for the constants a, b, c, d, the following applies: (a and c) > 0, b < 0 and d = s - t.

5. Doctor blade (20) according to claim 3, **characterized in that** for the cuboidal course f(x) of the curved blade profile (25), the following applies for the constants a, b and c:

$$0{,}000485 \leq a \leq 0{,}0021953,$$

$$3{,}33158 \leq b \leq 4{,}545127$$

and

$$1{,}468371 \leq c \leq 25{,}0128.$$

6. Doctor blade (20) according to claim 3, **characterized in that** for the cuboidal course f(x) of the curved blade profile (25), the following applies for the constants a, b and c:

$$0{,}00068 \leq a \leq 0{,}00158,$$

$$3{,}3321 \leq b \leq 4{,}5416$$

and

$$10{,}19478 \leq c \leq 10{,}2501.$$

7. Doctor blade (20) according to one of claims 3 to 6, **characterized in that** for the thickness s of the doctor blade (20) at the doctor blade edge (21) and the thickness t of the doctor blade (20) at the doctor blade body (22), the following applies:

$$60 \, \mu m \leq s \leq 125 \, \mu m$$

and

$$150 \, \mu m \leq t \leq 200 \, \mu m.$$

8. Doctor blade (20) according to one of claims 1 to 7, **characterized in that** the doctor blade (20) is made of a ground steel strip.

**Revendications**

1. Racle (20), en particulier pour des cylindres d'impression et des installations d'enduction, avec un bord de racle (21), un corps de racle (22), qui est délimité par une face supérieure de racle (23) et une face inférieure de racle (24), et un profil de lamelle (25) en forme d'arc, qui est formé entre le bord de racle (21) et le corps de racle (22), **caractérisée, en ce que** le profil de lamelles (25) en forme d'arc présente, à l'état non chargé de la racle (20) et par rapport à un système de coordonnées cartésiennes, un tracé cubique f(x) depuis le bord de la racle (21) jusqu'au corps de la racle (22), l'axe y du système de coordonnées cartésiennes coïncidant avec le bord de la racle (21) et l'axe x du système de coordonnées cartésiennes coïncidant avec la face supérieure de la racle (23).

2. Racle (20) selon la revendication 1, **caractérisée en ce que** le tracé cubique f(x) du profil de lamelle (25) en forme d'arc possède un point d'inflexion (26).

3. Racle (20) selon la revendication 1, **caractérisée en ce que** pour le tracé f(x) du profil de lamelle (25) en forme d'arc de la racle (20) avec une épaisseur s au bord de la racle (21) et une épaisseur t au corps de la racle (22), on a du bord de la racle (21) jusqu'au corps de la racle (22) : $f(x) = ax^3 + bx^2 + cx + d$, avec les constantes a, b, c, d suivantes : $a > 0$, (b et c) $\geq 0$ et $d = s - t$.

4. Racle (20) selon la revendication 1, **caractérisée en ce que** pour le tracé f(x) du profil de lamelle (25) en forme d'arc de la racle (20) avec une épaisseur s au bord de la racle (21) et une épaisseur t au corps de la racle (22), on a du bord de la racle (21) jusqu'au corps de la racle (22): $f(x) = ax^3 + bx^2 + cx + d$, où pour les constantes a, b, c, d on a : (a et c) $> 0$, $b < 0$ et $d = s - t$.

5. Racle (20) selon la revendication 3, **caractérisée en ce que**, pour le tracé cubique f(x) du profil de lamelle (25) en forme d'arc, on a pour les constantes a, b et c :

$$0{,}000485 \leq a \leq 0{,}0021953,$$

$$3{,}33158 \leq b \leq 4{,}545127$$

et

$$1{,}468371 \leq c \leq 25{,}0128.$$

6. Racle (20) selon la revendication 3, **caractérisée en ce que**, pour le tracé cubique f(x) du profil de lamelle (25) en forme d'arc, on a pour les constantes a, b et c :

$$0{,}00068 \leq a \leq 0{,}00158,$$

$$3{,}3321 \leq b \leq 4{,}5416$$

et

$$10{,}19478 \leq c \leq 10{,}2501.$$

7. Racle (20) selon l'une des revendications 3 à 6, **caractérisée en ce que** pour l'épaisseur s de la racle (20) au niveau du bord de la racle (21) et l'épaisseur t de la racle (20) au niveau du corps de la racle (22), on a :

$$60\ \mu\mathrm{m} \leq s \leq 125\ \mu\mathrm{m}$$

et

$$150\ \mu m \le t \le 200\ \mu m.$$

8. Racle (20) selon l'une des revendications 1 à 7, **caractérisée en ce que** la racle (20) est fabriquée à partir d'une bande d'acier rectifiée.

**Fig. 1a** (Stand der Technik)

## Fig. 1b (Stand der Technik)

a)

b)

c)

## <u>Fig. 1c</u> (Stand der Technik)

Fig. 2b

Fig. 2a

Fig. 2c

Fig. 3a

Fig. 3b

EP 4 214 056 B1

Fig. 4a

f6(x)

f5(x)

25

21

22

l

x

S

L5

y= f(x)

20

Fig. 4b

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- AT 349423 B
- DE 10120117 A1
- DE 19512696 A1
- DE 60120483 T2
- DE 69527829 T2
- EP 61093 A1
- EP 1930160 A1
- FR 2707918 A1
- US 4055119 A
- US 5685221 A
- US 20080257184 A1
- US 20090120355 A1
- WO 1992006796 A1
- US 6527913 B1